# EUROPEAN PATENT APPLICATION

(11) **EP 4 661 610 A1**
(43) Date of publication of application: **10.12.2025**
(21) Application number: 24749504.7
(22) Date of filing: 08.01.2024
(51) Int. Cl.: H05K 7/20

(54) **HEAT DISSIPATION DEVICE**

(30) Priority: 03.02.2023 CN 202310124796
(71) Applicant: Beijing NAURA Microelectronics Equipment Co., Ltd., Beijing 100176 (CN)
(72) Inventor: YAN, Zhishun, Beijing 100176 (CN); LIU, Tong, Beijing 100176 (CN); ZHAO, Jiabin, Beijing 100176 (CN); ZHAO, Fuping, Beijing 100176 (CN); ZHENG, Jianyu, Beijing 100176 (CN); LI, Buzhong, Beijing 100176 (CN)
(74) Representative: Cohausz & Florack
(86) International application number: PCT/CN2024/071134
(87) International publication number: WO 2024/160022

(57) **Abstract**

The present disclosure provides a heat dissipation device, relating to the technical field of photovoltaic cell process equipment, which is designed to solve the problem of long dwell time of hot air inside the housing. The heat dissipation device is configured for cooling a storage area inside the housing. The heat dissipation device includes an air suction frame and an air exhaust element. The air suction frame is arranged inside the housing. The air suction frame includes a frame chamber, an air suction port and an air guide port both communicating with the frame chamber. The air suction port faces a storage position. The air exhaust element is mounted to the housing. The air exhaust element is mounted at the housing. The air exhaust element is configured to provide power for discharging the airflow from the air guide port. In the present disclosure, the dwell time of the hot air inside the housing is shortened.

## Description

### TECHNICAL FIELD

The present disclosure generally relates to the photovoltaic cell process equipment technology field and, more particularly, to a heat dissipation device.

### BACKGROUND

With the continuous expansion of the photovoltaic power generation market, the demand for production capacity of Plasma Enhanced Chemical Vapor Deposition (PECVD) equipment used for wafer coating in photovoltaic cell manufacturing is also constantly increasing. At present, PECVD equipment has developed from a five-tube system to a six-tube system, and a number of process wafers per single tube has increased from 400 wafers to 704 wafers. However, the increase in PECVD equipment size and the number of process wafers also brings some problems, such as (1) a graphite boat inside the housing cools down slowly, which affects productivity, and (2) heat that is to be dissipated is large in amount during a heat dissipation process, and hot air remains inside the housing for too long to cause elements of the housing to be burned, which lead to safety incidents such as boat collisions and element damages.

Therefore, to improve productivity and equipment reliability, how to achieve rapid cooling of the graphite boat inside the housing has become an urgent technical problem to be solved.

### SUMMARY

The purpose of the present disclosure is to provide a heat dissipation device to solve the technical problem of dwell time of hot air inside a housing being too long.

The heat dissipation device of the present disclosure is configured to cool a storage area inside the housing. The heat dissipation device includes an air suction frame and an air exhaust element.

The air suction frame is arranged inside the housing. The air suction frame includes a frame chamber, an air suction port and an air guide port communicating with the frame chamber. The air suction port faces a storage position.

The air exhaust element is mounted at the housing. The air exhaust element is configured to provide power for discharging an airflow from the air guide port.

**In** some embodiments, the air suction frame includes a longitudinal beam and a crossbeam mounted at the longitudinal beam. The longitudinal beam and the crossbeam have hollow beam structures. An inner chamber of the crossbeam communicates with an inner chamber of the longitudinal beam. The inner chamber of the crossbeam and the inner chamber of the longitudinal beam together form the frame chamber. The air suction port is formed at the crossbeam, and the air guide port is formed at the longitudinal beam.

**In** some embodiments, a plurality of crossbeams is provided, arranged at intervals along an extension direction of the longitudinal beam, and are in a one-to-one correspondence with a plurality of storage positions of the housing.

**In** some embodiments, an extension direction of the crossbeam is substantially parallel to a length direction of the storage position.

**In** some embodiments, a plurality of air suction ports is provided at the crossbeam and arranged at intervals along an extension direction of the crossbeam.

**In** some embodiments, the housing includes an air outlet port, and the air guide port communicates with the air outlet port to allow the airflow discharged from the air guide port to be discharged outside of the housing from the air outlet port.

**In** some embodiments, the housing further includes an air supply port. The heat dissipation device further includes a cooling assembly. The cooling assembly is configured to cool air outside the housing and send the air into the housing through the air supply port.

**In** some embodiments, the air supply port is located above a moving path of an object to be cooled entering the housing.

**In** some embodiments, the cooling assembly includes a shell body and a cooling element. The shell body is fixedly connected to the housing. The shell body includes a cooling chamber. The air outlet port and the air supply port communicate with the cooling chamber. The air exhaust element is further configured to provide power for airflow to flow from the air outlet port to the air supply port. The cooling element is arranged in the cooling chamber. The cooling chamber is located in a flow path from the air outlet port to the air supply port.

**In** some embodiments, the shell body further includes a uniform flow chamber. The uniform flow chamber is arranged between the air outlet port and the cooling chamber. The uniform flow chamber includes a uniform flow element. The uniform flow element is configured to cause the airflow entering the uniform flow chamber to be uniformly distributed in a determined direction. The determined direction is substantially perpendicular to the flow path of the airflow from the air outlet port to the air supply port.

In some embodiments, the uniform flow element includes a uniform flow board and a disturbance flow board fixedly connected to the shell body. The uniform flow board includes a plurality of uniform flow holes arranged at intervals in the determined direction. The uniform flow chamber and the cooling chamber are arranged on two sides of the uniform flow board, respectively, and communicate via the plurality of uniform flow holes. The disturbance flow board is configured to guide the airflow entering the uniform flow chamber along the determined direction.

In some embodiments, a side wall of the shell body includes an air inlet port. The air inlet port communicates with the air outlet port. The uniform flow chamber is arranged between the air inlet port and the cooling chamber. An instant flow direction of the airflow passing through the air inlet port is along the determined direction, and the disturbance flow board faces the air inlet port. The disturbance flow board and the uniform flow board are arranged at an interval to form an airflow channel between a side edge of the disturbance flow board and the uniform flow board along the determined direction. The disturbance flow board includes a plurality of disturbance flow holes arranged in a dispersed manner.

In some embodiments, the air inlet port communicates with the air outlet port through a connection pipeline.

In some embodiments, the shell body further includes an air supply chamber. The air supply chamber communicates with the cooling chamber with the air supply port. The air exhaust element is arranged between the cooling chamber and the air supply chamber. An inlet of the air exhaust element faces the cooling chamber, and an outlet of the air exhaust element faces the air supply chamber.

In some embodiments, the air supply chamber includes a flow guide segment. The flow guide segment is arranged between the air exhaust element and the air supply port, and a flow through area of the air guide segment gradually decreases in a direction from the air exhaust element to the air supply port.

In some embodiments, the air supply port is formed at a top wall of the housing. The cooling assembly is arranged on the top wall of the housing. The uniform flow chamber, the cooling chamber, and the air supply chamber are arranged sequentially in a horizontal direction.

In some embodiments, an air supply grille is provided at a bottom wall of the air supply chamber. The air supply grille faces the air supply port. The air supply chamber communicates with the air supply port through the air supply grille.

In some embodiments, the cooling element includes a finned tube heat exchanger. A heat exchange body of the finned tube heat exchanger is accommodated in the cooling chamber. A liquid inlet and a liquid outlet of the finned tube heat exchanger are both provided on the side wall of the shell body.

In some embodiments, the shell body is detachably and fixedly connected to the housing.

The heat dissipation device of the present disclosure can bring the following beneficial effects.

When this heat dissipation device is in use, the air suction port of the air suction frame faces the storage position inside the housing. The object to be cooled is placed at the storage position. The air guide port of the air suction frame communicates with the air suction port through the frame chamber. When the air exhaust element is activated, the air exhaust element can provide power to discharge the airflow from the air outlet port to increase the airflow pressure at the air guide port. Then, the frame chamber can form a negative pressure area to allow the air heated by the object to be cooled at the storage position to be sucked into the frame chamber through the air suction port to flow to the air guide port to finish the heat dissipation.

In the method of discharging the hot air at the storage position using the air suction port of the air suction frame, the air suction port directly can face the storage position of the object to be cooled. That is, the air suction port can face the area where the heat inside the housing is concentrated. On one hand, the heat dissipation process can be more targeted, so that the heat generated by the object to be cooled can promptly move away from the object to be cooled, which reduces the dwell time of the hot air around the object to be cooled. On another hand, the hot air, after being drawn into the frame chamber body by the air suction port, can be directly discharged through the air guide port (e.g., discharged outside the housing, or, a cooling assembly being installed inside the housing to cool the hot air discharged through the air guide port and convert the hot air into cold air, which can be then directly reintroduce into the housing). Thus, large-scale movement of hot air inside the housing can be avoided, the dwell time of hot air inside the housing can be shortened, and the distribution area of hot air inside the housing can be reduced. The problem of electrical elements inside the housing being burned can be effectively solved, and the reliability of the equipment can be ensured.

**In** addition, with the configuration form of the heat dissipation device, the tedious steps of using plant pipelines for heat dissipation as in the past can be eliminated. Thus, the cost can be saved, and the situation of poor heat dissipation due to long plant pipelines and large pipeline resistance can be improved.

### BRIEF DESCRIPTION OF THE DRAWINGS

**In** order to more clearly illustrate the technical solutions in the embodiments of the present disclosure or the related technology, the drawings used in the description of the embodiments or related technology will be briefly introduced below. Obviously, the drawings described below are only some embodiments recorded in the present disclosure. For those of ordinary skill in the art, other drawings can also be obtained based on these drawings without creative effort.
FIG. 1 is a schematic layout diagram of a heat dissipation device configured to dissipate heat for a graphite boat in the related technology.
FIG. 2 is a schematic structural diagram showing a heat dissipation device using a water cooling coil fan to dissipate heat for a graphite boat in the related technology.
FIG. 3 is a schematic diagram of a heat dissipation device configured to dissipate heat for a graphite boat in the related technology.
FIG. 4 is a schematic layout diagram of a heat dissipation device relative to a housing, where the housing is a schematic external structure according to an embodiment of the present disclosure.
FIG. 5 is a schematic layout diagram of another heat dissipation device relative to a housing, where the housing is a schematic internal structure according to an embodiment of the present disclosure.
FIG. 6 is a schematic external structural diagram of a housing configured to mount a heat dissipation device according to an embodiment of the present disclosure.
FIG. 7 is a schematic overall structural diagram of a heat dissipation device according to an embodiment of the present disclosure.
FIG. 8 is a schematic diagram showing positions of a graphite boat and a storage position inside a housing according to an embodiment of the present disclosure.
FIG. 9 is a schematic layout diagram of a heat dissipation device relative to a graphite boat and a storage position according to an embodiment of the present disclosure.
FIG. 10 is a schematic structural diagram of an air suction frame of a heat dissipation device according to an embodiment of the present disclosure.
FIG. 11 is a schematic internal structural diagram of a cooling assembly of a heat dissipation device according to an embodiment of the present disclosure.

### Reference numerals:

| | | | | | | | |
|---|---|---|---|---|---|---|---|
| 1' | Water cooling coil fan | 2' | Plant exhaust | 3' | Door panel | 4' | Storage position |
| 5' | Graphite boat | 6' | Housing | | | | |
| 010 | Housing | 020 | Graphite boat | 030 | Heat dissipation device | | |
| 040 | Storage position | | | | | | |
| 011 | Air outlet port | 012 | Air supply port | | | | |
| 100 | Air suction frame | 200 | Air exhaust element | 300 | Cooling assembly | | |
| 400 | Connection pipe | | | | | | |
| 110 | Longitudinal beam | 111 | Air guide port | 120 | Cross beam | | |
| 121 | Air suction port | | | | | | |
| 310 | Shell body | 320 | Cooling element | 330 | Uniform flow element | | |
| 340 | Flow guidance board | 350 | Block board | 360 | Dividing board | | |
| 370 | Air supply grille | 380 | Air inlet | | | | |
| 311 | Cooling chamber | 312 | Uniform flowchamber | 313 | Air supply chamber | | |
| 3131 | Flow guidance segment | | | | | | |
| 331 | Uniform flow board | 3311 | Uniform flow hole | 332 | Disturbance flow board | | |
| 3321 | Disturbance flow hole | 333 | Air flow channel | | | | |

### DETAILED DESCRIPTION OF THE EMBODIMENTS

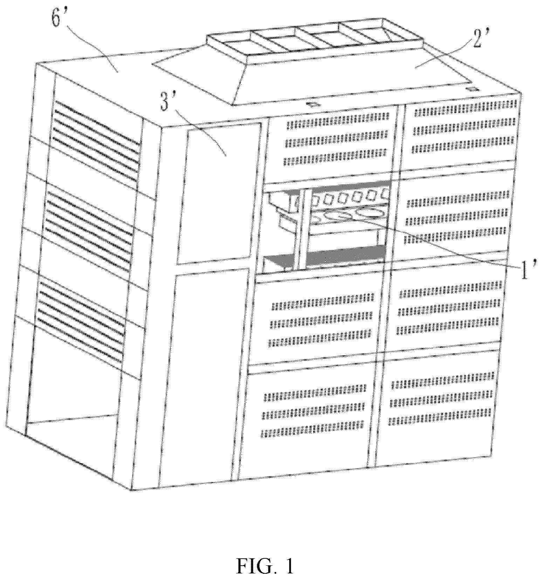

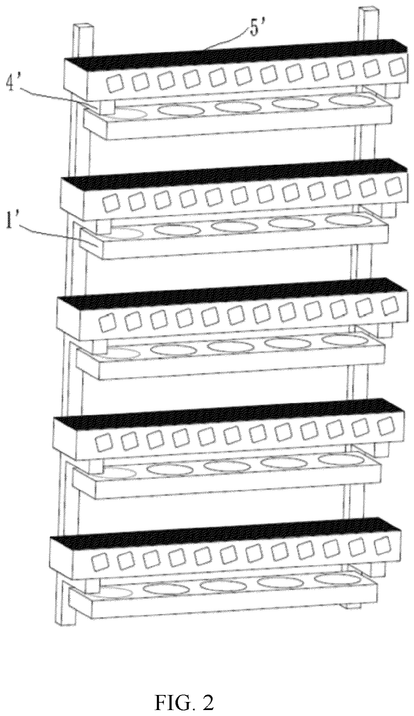

FIG. 1 is a schematic layout diagram of a heat dissipation device configured to dissipate heat of a graphite boat 5' in the related technology. FIG. 2 is a schematic structural diagram showing the heat dissipation device using a water cooling coil fan 1' to dissipate heat of the graphite boat 5' in the related technology. As shown in FIGS. 1 and 2, in the heat dissipation device of the related technology, a plant exhaust 2' is provided at the top of the housing 6', and the water-cooled coil fans 1' are arranged in the space directly below the graphite boats 5' at each storage position 4', respectively.

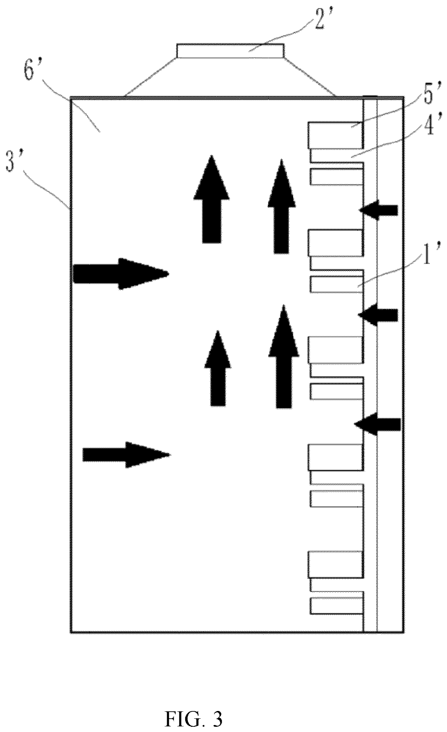

FIG. 3 is a schematic diagram of the heat dissipation device configured to dissipate heat of the graphite boat 5' in the related technology. As shown in FIG. 3, the heat dissipation device uses forced air convection as a heat dissipation method. In some embodiments, the water-cooled coil fan 1' can perform heat exchange for local air field convection. Meanwhile, external environmental air can enter the internal space of the housing 6' through a circular hole formed in the door panel 3' to exchange heat with the graphite boat 5' and can be discharged from the plant exhaust 2' at the top of the housing 6'. In FIG. 3, the arrows indicate the airflow path.

When the above heat dissipation device is in use, after the external environmental air enters from the door panel 3', most of the air can flow upward along the surface of the door panel 3' and is directly drawn away by the plant exhaust 2', without passing through the area where the storage position 4' is located. Thus, the graphite boat 5' placed at the storage position 4' may not have sufficient heat exchange, the cooling time can be too long, and productivity can be affected. Moreover, due to insufficient convective heat exchange in the area where the storage position 4' is located, the high-temperature heat emitted by the graphite boat 5' can spread to other areas inside the housing 6' to cause the internal temperature of the housing 6' to rise. The high-temperature air can flow in a large area and for a long time inside the housing 6'. Thus, the internal electrical elements of the housing 6' can be affected by the high temperature for a long time. The lifetime can be shortened. Meanwhile, in the method of using the water cooling coil fan 1' to enhance the air turbulence intensity of the area where the storage position 4' is located, the heat exchange effect may not be enhanced obviously. Moreover, each additional water cooling coil fan 1' can increase water leaking risk and increase equipment cost.

In addition, in the method of using a negative pressure generated when the plant exhaust 2' draws out the hot air as an airflow drive power inside the housing 6', the pipeline of the plant exhaust 2' can be long, the pipeline can be subjected to a large resistance, and construction cost and the operation cost of the plant exhaust 2' can be high. Moreover, when the heat dissipation device is used, the air inlet method inside the housing 6' can be an environmental air inlet, which causes the process wafer inside the housing 6' to be contaminated by dust.

To make the above objectives, features, and advantages of the present disclosure more apparent and understandable, the embodiments of the present disclosure are described in detail below with reference to the accompanying drawings. It should be understood that the specific embodiments described here are merely used to explain, not to limit, the present invention.

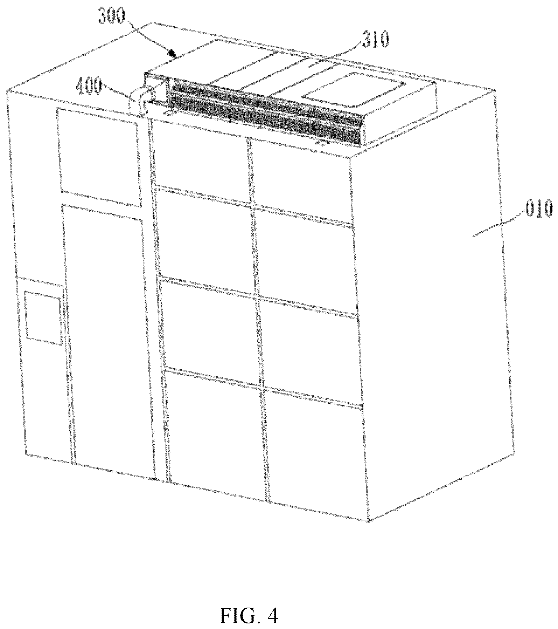

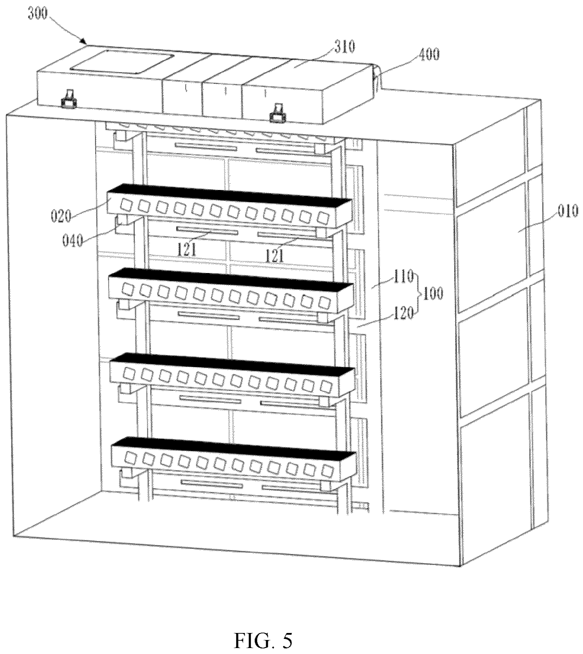

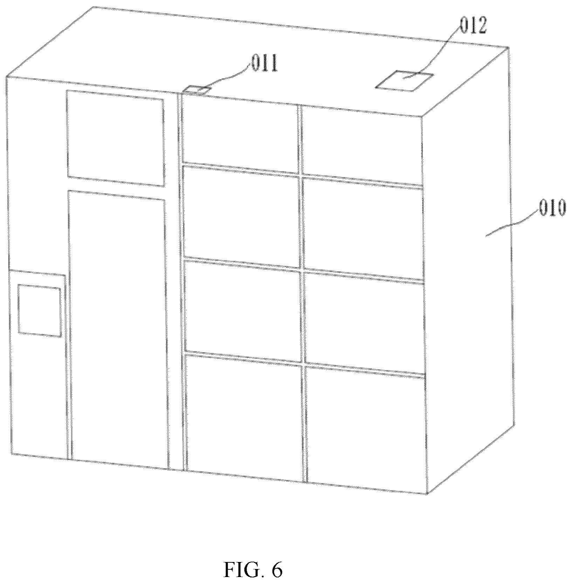

FIG. 4 is a schematic layout diagram of the heat dissipation device relative to the housing 010 (e.g., a schematic external structure of the housing 010) according to an embodiment of the present disclosure. FIG. 5 is a schematic layout diagram of the heat dissipation device relative to the housing 010 (e.g., a schematic internal structure of the housing 010) according to an embodiment of the present disclosure. As shown in FIGS. 4 and 5, embodiments of the present disclosure provide a heat dissipation device configured to cool the area of the storage position 040 inside housing 010. An object to be cooled stored at storage position 040 may be a graphite boat 020. FIG. 6 is a schematic external structural diagram of the housing 010 of the heat dissipation device according to an embodiment of the present disclosure.

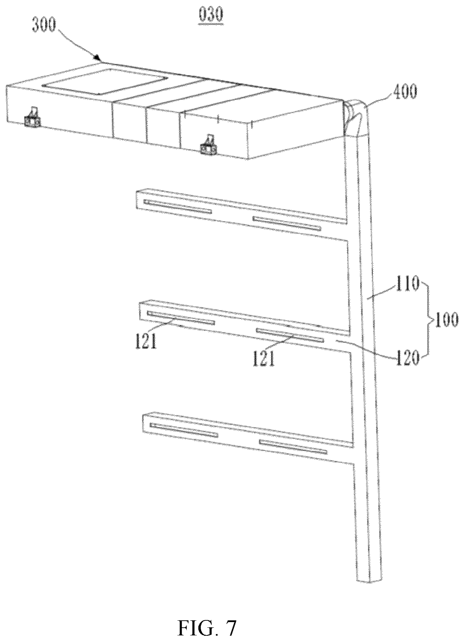

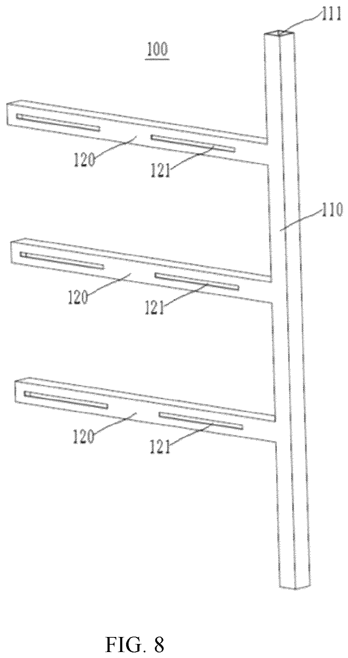

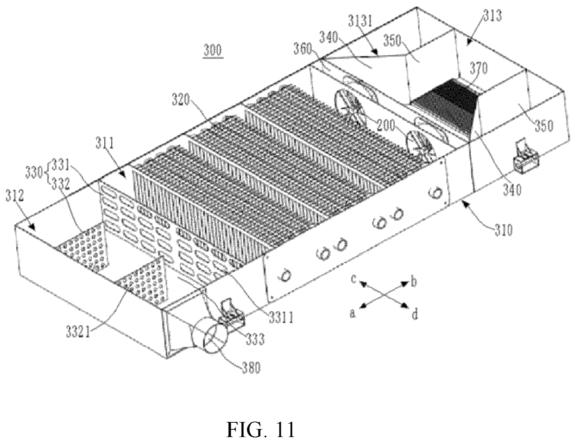

FIG. 7 is a schematic overall structural diagram of the heat dissipation device 030 according to an embodiment of the present disclosure. FIG. 8 is a schematic structural diagram of an air suction frame 100 of the heat dissipation device 030 according to an embodiment of the present disclosure. As shown in FIGS. 7 and 8, the heat dissipation device 030 includes an air suction frame 100 and an air exhaust element 200 (shown in FIG. 11). In some embodiments, as shown in FIG. 5, the suction frame 100 is arranged inside the housing 010, and the air suction frame 100 includes a frame chamber body and an air suction port 121 and an air guide port 111 communicating with the frame chamber body. The frame chamber body is an internal chamber formed inside the air suction frame 100.

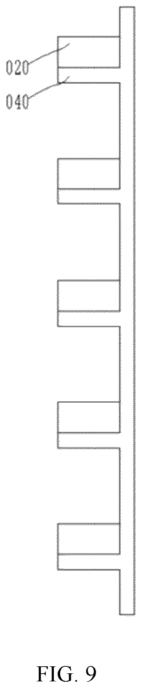

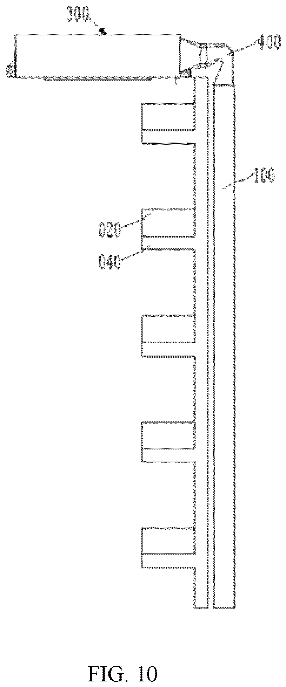

FIG. 9 is a schematic diagram showing the positions of the graphite boat 020 and the storage position 040 inside the housing 010. FIG. 10 is a schematic layout diagram of the heat dissipation device 030 relative to the graphite boat 020 and storage position 040 according to an embodiment of the present disclosure. Please continue to refer to FIG. 5 and in connection with FIGS. 9 and 10, the air suction port 121 of the air suction frame 100 faces the storage position 040. It is easily understood that FIGS. 9 and 10 only virtually show the position of the graphite boat 020 at the storage position 040 and do not show the physical structure as in FIG. 5.

FIG. 11 is a schematic internal structural diagram of a cooling assembly 300 of the heat dissipation device 030 according to an embodiment of the present disclosure. Please continue to refer to FIG. 5 and in connection with FIG. 11, the exhaust element 200 is installed in the housing 010 and is configured to provide the power for the airflow to be discharged from the air guide port 111.

When the heat dissipation device 030 is in use, the air suction port 121 of the air suction frame 100 can face the storage position 040 inside the housing 010. For example, as shown in FIG. 5, for each storage position 040, a plurality of air suction ports 121 are provided, e.g., 2. The plurality of air suction ports 121 can be distributed below and near the graphite boat 020 of a corresponding storage position 040. The graphite boat 020 is arranged at the storage position 040. The air guide port 111 of the air suction frame 100 communicates with the air suction ports 121 through the frame chamber body. After the exhaust element 200 is started, the exhaust element 200 can provide the power to discharge the airflow from the air guide port 111 to increase the airflow pressure at the air guide port 111. Then, the frame chamber body can form a negative pressure area to cause the air heated by the graphite boat 020 at the storage position 040 can be sucked into the frame chamber body to flow to the air guide port 111 to complete the heat dissipation.

With the method of using the air suction port 121 of the air suction frame 100 to discharge the hot air at the storage position 040, since the air suction port 121 directly faces the storage position 040 of the graphite boat 020, i.e., the air suction port 121 faces the heat-concentrated area inside the housing 010, on one hand, makes the heat dissipation process can be more targeted, so that the heat generated by the graphite boat 020 can promptly move away from the graphite boat 020, which reduces the dwell time of the hot air around the graphite boat 020, and on another hand, the hot air, after being drawn into the frame chamber body by the air suction port 121, can be directly discharged through the air guide port 111 (e.g., discharged outside the housing 010, or, a cooling assembly being installed inside the housing 010 to cool the hot air discharged through the air guide port 111 and convert the hot air into cold air, which can be then directly reintroduce into the housing 010). Thus, the large-scale movement of hot air inside the housing 010 can be avoided, the dwell time of hot air inside the housing 010 can be shortened, and the distribution area of hot air inside the housing 010 can be reduced. The problem of electrical elements inside housing 010 being burned can be effectively solved, and the reliability of the equipment can be ensured.

In addition, with the configuration form of the heat dissipation device 030, the tedious steps of using plant pipelines for heat dissipation as in the past can be eliminated. Thus, the cost can be saved, and the situation of poor heat dissipation due to long plant pipelines and large pipeline resistance can be improved.

It should be noted that the object to be cooled is exemplarily described as the graphite boat 020. It can be understood that the object to be cooled can also include other items that need to be cooled. In embodiments of the present disclosure, the structure and principle of the heat dissipation device can be exemplarily described by taking an example that the heat at the storage position 040 is generated by the graphite boat 020, which is not used to limit the present disclosure.

As shown in FIG. 6, in some embodiments, the housing 010 includes an air outlet 011. In some embodiments, the air guide port 111 of the air suction frame 100 communicates with the above-mentioned air outlet 011, so that the airflow discharged from the air guide port 111 is discharged to the outside of the housing 010 through the air outlet 011.

By providing an air outlet 011 on the housing 010, the hot air around the graphite boat 020 can be drawn by the air suction port 121 of the air suction frame 100, flow to the air guide port 111, and then be discharged to the outside of the housing 010 via the air outlet 011 of the housing 010. Thus, the hot air can be prevented from staying inside the housing 010 for a long time.

As shown in FIG. 6, in some embodiments, the air outlet 011 is formed on a top wall of the housing 010. With such a configuration, the feature that the hot air rises upward can be effectively used to allow the hot air inside the housing to have the tendency of moving toward the air outlet 011. Thus, the hot air can be facilitated to be discharged, and the air suction resistance of the air resistance element 200 can be reduced.

As shown in FIGS. 5, 7, and 8, in some embodiments, the air suction frame 100 includes a longitudinal beam 110 and a crossbeam 120 mounted on the longitudinal beam 110. In some embodiments, both the longitudinal beam 110 and the crossbeam 120 have hollow beam structures, and the inner chamber of the crossbeam 120 communicates with the inner chamber of the longitudinal beam 110. The inner chamber of the crossbeam 120 and the inner chamber of the longitudinal beam 110 together form the frame chamber. The air suction port 121 is formed at the crossbeam 120, and the air guide port 111 is formed at the longitudinal beam 110.

When the heat dissipation device 030 is operating, under the action of the air exhaust element 200, the heat emitted from the graphite boat 020 placed at the storage position 040 can first enter the frame chamber through the air suction port 121 formed at the crossbeam 120, and then be discharged through the air guide port 111 formed at the longitudinal beam 110 to dissipate the heat. With the method of performing heat dissipation using the air suction frame 100, the hot air can be prevented from flowing widely inside the housing 010 to solve the problem of the electrical elements inside the housing 010 being burned, and improve the heat dissipation efficiency of the graphite boat 020. Moreover, the occupation of the internal space of the housing 010 can be reduced to improve the space utilization.

In some other embodiments, an air suction box can also be used to replace the air suction frame 100 for air suction. Then, the frame chamber body can be formed in the internal space of the air suction box. Meanwhile, holes communicating with the internal space can be formed on the box walls of the air suction box to form the air suction port 121 and the air guide port 111. With this configuration, the hot air can also be prevented from flowing widely inside the housing 010.

In some embodiments, the longitudinal beam 110 and the crossbeam 120 of the air suction frame 100 may both be made of stainless steel. The air suction frame 100 can be obtained by fixedly welding the longitudinal beam 110 and the crossbeam 120.

As shown in FIGS. 5, 7, and 8, in some embodiments, a plurality of crossbeams 120 are provided. The plurality of crossbeams 120 are arranged at intervals along the extension direction of the longitudinal beam 110. The plurality of crossbeams 120 have a one-to-one correspondence with the plurality of storage positions 040 of the housing 010.

With the above configuration, on one aspect, each storage position 040 can be ensured to be provided with a crossbeam 120 having the air suction port 121. Then, the air suction port 121 of each crossbeam 120 can suck the hot air at the corresponding storage position 040. The flowing of the hot air between any two neighboring storage positions 040 can be eliminated, and the heat exchange effect can be enhanced in the area of the storage position 040. On another aspect, with the plurality of crossbeams 120, the number of air suction ports 121 can be increased, and the distribution area of the air suction ports 121 along the length direction of the longitudinal beam 110 can be enlarged to allow the hot air inside the housing 010 to be timely and sufficiently discharged to the outside to further improve the heat dissipation efficiency.

As shown in FIG. 5, in some embodiments, the extension direction of the crossbeam 120 is basically parallel to the length direction of the storage position 040. The length direction of the storage position 040 is the length direction of the graphite boat 020. That is, the extension direction of the crossbeam 120 is basically parallel to the length direction of the graphite boat 020, i.e., the left-right direction in the view angle of FIG. 5.

Through this configuration, the effective area of the air suction port 121 can be increased, and the distance between the crossbeam 120 and the storage position 040 can be minimized. Thus, the heat generated at various positions along the length direction of the graphite boat 020 can be quickly sucked away to further improve the heat dissipation efficiency.

In some embodiments, the cross-sectional shape of the housing 010 can be a rectangle, and the air suction frame 100 can be fixed inside the housing 010. The extension direction of the crossbeam 120 can be basically parallel to the length direction of the graphite boat 020. That is, the air suction frame 100 can be arranged between the storage position 040 and a housing wall corresponding to a long edge of the rectangle.

It should be noted that "the extension direction of the crossbeam 120 being basically parallel to the length direction of the storage position 040" can include the situation in which the extension direction of the crossbeam 120 is parallel to the length direction of the storage position 040 and the situation in which the extension direction of the crossbeam 120 forms a certain angle with the length direction of the storage position 040. The angle can be between -5° and 5°.

In some embodiments, the air suction frame 100 can be fixed to the housing wall of the housing 010 by a bolt connection.

As shown in FIGS. 5, 7, and 8, in some embodiments, a plurality of air suction ports 121 are provided at the crossbeam 120. The plurality of air suction ports 121 are arranged at intervals along the extension direction of the crossbeam 120.

With this configuration of providing the plurality of air suction ports 121 along the extension direction of the crossbeam 120, the number of air suction ports 121 can be increased, and the distribution area of the air suction ports 121 can be increased. Thus, the hot air at the area of the storage position 040 can be quickly sucked away. Moreover, the plurality of air suction ports 121 arranged at intervals can be used to enrich the configuration forms of the air suction area, and the structural strength of the crossbeam 120 can be ensured. Then, the structural deformation of the crossbeam 120 can be reduced.

As shown in FIGS. 4 to 6, in some embodiments, an air supply port 012 is provided at the housing 010. The heat dissipation device further includes a cooling assembly 300. The cooling assembly 300 can be configured to cool and send the air outside the housing 010 into the inside of the housing 010 through the air supply port 012.

While the air suction frame 100 is configured to suck the hot air from the inside of the housing 010, the cooling assembly 300 can operate to cool the external air of the housing 010 and send the cooled air into the inside of the housing 010 via the air supply port 012. The graphite boat 020 can be cooled by convective heat exchange to realize the cooling process for the graphite boat 020.

That is, while the heat dissipation device 030 continuously outputs the internal hot air of the housing 010 by using the air suction frame 100, the cooling assembly 300 can be configured to input the cold air into the inside of the housing 010 to greatly improve the heat dissipation efficiency of the graphite boat 020. Then, the graphite boat 020 can be quickly cooled, the cooling time of the graphite boat 020 can be effectively shortened, and the equipment production capability can be improved.

In other embodiments, the cooling assembly 300 can also be arranged inside the housing 010. Then, the hot air discharged from the air guide port of the air suction frame 100 can directly enter the inside of the cooling assembly 300 inside the housing 010, can be cooled by the cooling assembly 300, and then be directly sent back into the housing 010 to cool the graphite boat 020.

With this arrangement in which the cooling assembly 300 is arranged inside the housing 010, the cold air can also be sent into the housing 010, and the airflow path can be shortened. In addition, with this configuration, the air used to cool the graphite boat 020 is still from the inside of the housing 010. The whole heat dissipation and cooling process may not have convection with the external air. Thus, the contamination of the process wafer that is caused when a large amount of air enters the inside of the housing 010 can be avoided.

In some embodiments, the air supply port 012 can be located above the motion path of the graphite boat 020 when the graphite boat 020 enters the housing 010. That is, the air supply port 012 can be arranged above the unloading zone at the furnace opening of the graphite boat 020. By arranging the air supply port 012 at the above position, when the unloading operation is performed on the graphite boat 020, the graphite boat 020 can exchange heat with the cooled air inputted from the air supply port 012. With this configuration, the problem of the excessive heat of the air at the top when the unloading is performed can be effectively solved.

As shown in FIG. 6, in some embodiments, the air supply port 012 is arranged on the top wall of the housing 010.

As shown in FIG. 11, in some embodiments, the cooling assembly 300 includes a shell body 310 and a cooling element 320. The shell body 310 is fixedly connected to the housing 010. The shell body 310 includes a cooling chamber 311. The air outlet 011 and the air supply port 012 are both in communication with the cooling chamber 311. The air exhaust element 200 is also configured to provide power for the air flowing from the air outlet 011 to the air supply port 012. The cooling element 320 is arranged at the cooling chamber 311. The cooling element 320 is at the flow path from the air outlet 011 to the air supply port 012.

When the heat dissipation device 030 operates, under the action of the air exhaust element 200, the air heated by the graphite boat 020 inside the housing 010 can flow from the air guide port 111 to the air outlet 0011 of the air suction frame 100 after being heated by the graphite boat 020 in the housing 010. Then, the hot air can enter the cooling chamber 311 from the air outlet 011 and can be cooled to reduce the temperature by the cooling element 320 arranged in the cooling chamber 311. Then, the air after the cooling and temperature reduction process can enter the inside of the housing 010 via the air supply port 012 to participate in the convective heat exchange with the graphite boat 020. With such a cycle, the graphite boat 020 can be cooled.

With this configuration of the cooling assembly 300, the same air exhaust element 200 can be configured to realize the output of hot air from inside the housing 010 and the input of external cold air into the housing 010. Thus, the air can be circulated between the inside and outside the housing 010. The cooling air for the graphite boat 020 can still be from the inside of the housing 010. That is, the self-circulation of the air inside the housing 010 can be used to output the hot air and input the cold air. The whole heat dissipation and cooling process may not involve convection with the external air. Thus, the contamination of the process wafer caused by a large amount of external air entering the inside of the housing 010 can be avoided.

**In** other embodiments, a non-air-circulating solution can also be provided. In this solution, the input of the hot air and the output of the cold air can be two independent processes. Then, a filter element can be provided at the air supply port 012, so that the cooled environment air can be filtered through the filter element first, and then enter the inside of the housing 010. With this configuration, the contamination of the process wafer inside the housing 010 can also be avoided.

As shown in FIG. 11, in some embodiments, a uniform flow chamber 312 is arranged in the shell body 310. In some embodiments, the uniform flow chamber 312 is arranged between the air outlet port 011 and the cooling chamber 311. That is, the uniform flow chamber 312 communicates with both the air outlet port 011 and the cooling chamber 311. The hot air output from the air outlet port 011 passes through the uniform flow chamber 312 and enters the cooling chamber 311. The uniform flow chamber 312 includes a uniform flow element 330. The uniform flow element 330 can be configured to allow the air entering the uniform flow chamber 312 to be uniformly distributed along a determined direction. The determined direction is basically perpendicular to the flow path of the airflow from the air outlet port 011 to the air supply port 012.

In some embodiments, the flow path of the airflow from the air outlet port 011 to the air supply port 012 is approximately along the direction from arrow a to arrow b in FIG. 11, and the determined direction is approximately along the direction indicated by arrow cd in FIG. 11.

With the uniform flow chamber 312, after the hot air inside the housing 010 flows to the shell body 310 via the air outlet port 011, the hot air can first enter the uniform flow chamber 312. The uniform flow element 330 can be configured to perform a uniform flow process on the airflow to allow the airflow entering the uniform flow chamber 312 to be evenly distributed along the determined direction. Thus, the airflow can enter the cooling chamber 311 uniformly. The poor cooling effect due to the airflow being non-uniformly distributed in the cooling chamber 311 can be avoided. The airflow can be ensured to be efficiently cooled to ensure the subsequent cooling and temperature reduction effect for the graphite boat 020.

It should be noted that the determined direction being substantially perpendicular to the flow path of the airflow from the air outlet port 011 to the air supply port 012 can include the determined diction being perpendicular to the flow path of the airflow from the air outlet port 011 to the air supply port 012 and the determined direction having a certain angle with the flow path of the airflow from the air outlet port 011 to the air supply port 012. The angle can be between 85° and 90°.

As shown in FIG. 11, in some embodiments, the uniform flow element 330 includes a uniform flow board 331 and a disturbance flow board 332 fixedly connected to the shell body 310. If the uniform flow board 331 includes a plurality of uniform flow holes 3311 arranged at intervals along the determined direction, the uniform flow chamber 312 and the cooling chamber 311 are arranged on two sides of the uniform flow board 331 and communicate through the plurality of uniform flow holes 3311. The disturbance flow board 332 can be configured to guide the airflow entering the uniform flow chamber 312 along the determined direction. In some embodiments, the surface of the uniform flow board 331 is parallel to the determined direction (e.g., along the direction indicated by arrow cd in FIG. 11). The uniform flow chamber 312 and the cooling chamber 311 are arranged on two sides perpendicular to the direction (e.g., the direction from arrow a to arrow b) of the surface of the uniform flow board 331.

When the airflow enters the uniform flow chamber 312 from the air outlet port 011, the airflow can first pass through the disturbance flow board 332. The disturbance flow board 332 can guide the airflow along the determined direction using a disturbance flow effect to allow the airflow to be uniformly distributed along the determined direction. After the airflow is guided along the determined direction, the airflow can gradually flow to the position of the uniform flow board 331 and can be distributed at various areas of the uniform flow board 331 along the determined direction. Thus, the airflow can enter the cooling chamber 311 through the uniform flow holes 3311 formed at the uniform flow board 331.

With the configuration of the uniform flow element 330, the internal space of the shell body 310 can be effectively divided to cause the internal space of the shell body 310 to form the uniform flow chamber 312 and the cooling chamber 311 arranged in sequence. Moreover, the uniform distribution of the airflow can also be ensured. Thus, the cooling effect of the cooling element 320 on the airflow can be enhanced.

In some embodiments, the uniform flow board 331 and the disturbance flow board 332 can be fixed in the internal space of the shell body 310 by welding.

As shown in FIG. 11, in some embodiments, an air inlet port 380 is formed on a side wall of the shell body 310. The air inlet port 380 communicates with the air outlet port 011. The uniform flow chamber 312 is between the air inlet port 380 and the cooling chamber 311. The instant flow direction of the airflow passing through the air inlet port 380 is along the determined direction. The disturbance flow board 332 faces the air inlet port 380. The disturbance flow board 332 and the uniform flow board 331 are arranged at an interval to form an airflow channel 333 extending along the determined direction between the side edge of the disturbance flow board 332 and the uniform flow board 331. The disturbance flow board 332 includes a plurality of disturbance flow holes 3321 arranged in a dispersed manner.

When the hot air inside the housing 010 flows out through the air outlet port 011, the hot air can enter the uniform flow chamber 312 through the air inlet port 380. After entering the uniform flow chamber 312, the speed of the airflow can be reduced under the blocking function of the uniform flow board 331. A portion of the airflow can flow toward the airflow channel 333, and another portion of the airflow can continue to flow forward through the disturbance holes 3321 of the disturbance flow board 332. Thus, the airflow entering the uniform flow chamber 312 can be uniformly distributed along the determined direction.

In some embodiments, a plurality of disturbance flow boards 332 can be provided. The plurality of disturbance flow boards 332 can be arranged at intervals along the determined direction.

It should be noted that the instant flow direction of the airflow passing through the air inlet port 380 can be the axis direction of the air inlet port 380.

As shown in FIG. 7 and FIG. 10, in some embodiments, the air inlet port 380 communicates with the air outlet port 011 through a connection pipeline 400. The connection pipeline 400 can be configured to realize the transition of the airflow from the air inlet port 380 to the air outlet port 011 to communicate the air inlet port 380 and the air outlet port 011, and reduce the cost without designing and manufacturing the shell body 310 and the air suction frame 100 in a special manner.

As shown in FIG. 11, in some embodiments, an air supply chamber 313 is arranged inside the shell body 310. In some embodiments, the air supply chamber 313 communicates the cooling chamber 311 with the air supply port 012. The air exhaust element 200 is arranged between the cooling chamber 311 and the air supply chamber 313, and the inlet of the air exhaust element 200 faces the cooling chamber 311, and the outlet of the air exhaust element 200 faces the air supply chamber 313.

When the air exhaust element 200 is in operation, a negative pressure can be formed at the inlet of the air exhaust element 200 facing the cooling chamber 311. Thus, the hot air inside the housing 010 can pass through the air suction frame 100, the air inlet port 380, and the uniform flow chamber 312 in sequence to flow to the cooling chamber 311. The hot air can be cooled by the cooling element 320. Then, the cooled air can enter from the inlet of the air exhaust element 200 and flow out from the outlet of the air exhaust element 200 to supply the cooled air into the air supply chamber 313. The cooled air can eventually enter the inside of the housing 010 through the air supply port 012 to participate in the heat exchange of the graphite boat 020.

With the configuration form of the air exhaust element 200, the power for the circulation of the airflow can be provided for the flow path of the inside of the housing 010 → air suction frame 100 → air outlet port 011 → uniform flow chamber 312 → cooling chamber 311 → air supply chamber 313 → air supply port 012 → back to the inside of housing 010. Moreover, the occupied space is few, and the internal space of the shell body 310 can be effectively saved.

**In** some embodiments, the air exhaust element 200 can be a booster fan. The air exhaust element 200 can be mounted in the internal space of the shell body 310 by bolts.

As shown in FIG. 11, in some embodiments, a dividing board 360 is fixedly arranged inside the shell body 310, and the air exhaust element 200 is mounted on the dividing board 360. Moreover, two air exhaust elements 200 are provided and arranged at an interval along the determined direction.

**In** other embodiments, the air exhaust element 200 can also be provided in other quantities. The number of air exhaust elements 200 can be adaptively selected according to the size of the shell body 310 and the required airflow power.

As shown in FIG. 11, in some embodiments, a flow guide segment 3131 is arranged in the air supply chamber 313. In some embodiments, the flow guide segment 3131 is arranged between the air exhaust element 200 and the air supply port 012. That is, the air exhaust element 200 communicates with the air supply port 012. The airflow output from the air exhaust element 200 can enter the air supply port 012 through the flow guide segment 3131 first, and then air supply chamber 313. The passing through area of the flow guide segment 3131 gradually decreases in the direction from the air exhaust element 200 to the air supply port 012.

With the configuration of the flow guide segment 3131, the airflow can be guided to allow the airflow to accurately flow to the air supply port 012 and reduce the diffusion of the airflow toward the outside area of the air supply port 012. Moreover, the pressure of the airflow can be increased due to the passing through area gradually decreasing to allow the airflow to flow to the storage position 040 of the graphite boat 020 as quickly as possible for heat exchange.

As shown in FIG. 11, in some embodiments, the air supply chamber 313 includes two flow guide boards 340 fixedly arranged in an arrow shape. The area between the two flow guide boards 340 forms the above-mentioned flow guide segment 3131. Moreover, the two flow guide boards 340 are connected to block boards 350, respectively, to form the air supply chamber 313 enclosed by the dividing board 360, the two guide flow boards 340, the two block boards 350, and a part of the side wall of the shell body 310.

As shown in FIG. 4 and FIG. 5, in some embodiments, the cooling assembly 300 is arranged on the top wall of the housing 010. The uniform flow chamber 312, the cooling chamber 311, and the air supply chamber 313 are arranged sequentially in the horizontal direction.

When the cooling assembly 300 is arranged on the top wall of the housing 010, the lateral space of the housing 010 may not be occupied, which is beneficial for reducing the occupied area of the housing 010. Furthermore, by arranging the uniform flow chamber 312, the cooling chamber 311, and the air supply chamber 313 in sequence along the horizontal direction, the top space of the housing 010 may not be excessively occupied, which is beneficial to reduce the overall height of the equipment.

As shown in FIG. 11, in some embodiments, an air supply grille 370 is arranged on the bottom wall of the air supply chamber 313. In some embodiments, the air supply grille 370 faces the air supply port 012, and the air supply chamber 313 communicates with the air supply port 012 via the air supply grille 370. With the air supply grille 370, the air supply chamber 313 can be ensured to communicate with the air supply port 012, and the structural strength of the shell body 310 may not be significantly reduced.

As shown in FIG. 11, in some embodiments, the cooling element 320 includes a finned tube heat exchanger. In some embodiments, the heat exchange body of the finned tube heat exchanger is accommodated in the cooling chamber 311. The liquid inlet and the liquid outlet of the finned tube heat exchanger are both provided on the side wall of the shell body 310. With this cooling element 320, the cooling effect on the airflow can be ensured, the structure can be simple, and the cooling element 320 can be easily arranged.

The liquid flowing in the finned tube heat exchanger can be water or another cooling liquid.

In some embodiments, the finned tube heat exchanger can be mounted and fixed in the cooling chamber 311 with bolts.

In other embodiments, an air conditioning system can also be arranged in the cooling chamber 311 to cool the hot air entering the cooling chamber 311. With this configuration, the hot air can also be cooled when the airflow is circulated.

In some embodiments, the shell body 310 can be detachably and fixedly connected to the housing 010. After the heat dissipation device 030 is used for a while, the cooling assembly 300 can be disassembled from the top of the housing 010 for maintenance to improve maintenance efficiency.

In some embodiments, the shell body 310 can be mounted and fixed to the top wall of the housing 010 using bolts.

The overall heat dissipation process of the heat dissipation device 030 can include the following processes. The air heated by the graphite boat 020 inside the housing 010 can be sucked away through the air suction ports 121 provided on the crossbeams 120 of the air suction frame 100 to enter the frame chamber of the air suction frame 100. The airflow can continue to flow from the air guide port 111 of the longitudinal beam 110 to the air outlet port 011 of the housing 010. Then, the airflow can flow to the cooling assembly 300 through the connection pipeline 400 and enter the uniform flow chamber 312 through the air inlet port 380 of the cooling assembly 300. The airflow can be decelerated by the disturbance flow board 332 first and uniformed by the uniform flow board 331 to enter he cooling chamber 311. Then, the airflow can exchange heat with the finned tube heat exchanger arranged in the cooling chamber 311. In the process, the hot air can flow through the finned tube heat exchange by passing through the gaps between the fins to exchange heat with the cooling liquid in the finned tube heat exchanger to cool the hot air to reduce the temperature of the hot air. Subsequently, the hot air after the heat exchange can flow to the air supply chamber 313 and eventually enter the inside of the housing 010 through the air supply grille 370 and the air supply port 012 to cool the graphite boat 020. In the above process, the power for the circulation of the airflow can be provided by the air exhaust element 200.

Although the present disclosure is disclosed above, the present disclosure is not limited to this. Those skilled in the art can make various changes and modifications without departing from the spirit and scope of the present disclosure. Therefore, the scope of the present disclosure should be subject to the scope of the claims.

Finally, it should also be noted that, in this specification, relational terms such as "first" and "second" are merely used to distinguish one entity or operation from another entity or operation and do not necessarily imply any actual relationship or order between the entities or operations. Furthermore, the term "comprising" or any of its variations is intended to cover non-exclusive inclusion, so that a process, method, article, or equipment that includes a series of elements is not limited to those elements but may include other elements not explicitly listed or elements inherent to such process, method, article, or equipment. Without further limitations, an element defined by the phrase "comprising a . . ." does not exclude the presence of other identical elements in the process, method, article, or equipment that includes the element.

In the above embodiments, orientation terms such as "inner," "outer," "upper," "lower," and "side" are all based on the illustrations in the accompanying drawings.

The above description of the disclosed embodiments enables those skilled in the art to implement or use the present disclosure. Various modifications to these embodiments are apparent to those skilled in the art. The general principles defined in the specification can be implemented in other embodiments without departing from the spirit or scope of the present disclosure. Therefore, the present disclosure is not limited to the embodiments shown here but conforms to the widest scope consistent with the principles and novel features disclosed in the present disclosure.

## Claims

1. A heat dissipation device, configured to cool a storage area inside a housing, comprising
an air suction frame and an air exhaust element, wherein:
the air suction frame is arranged inside the housing, the air suction frame includes a frame chamber, and an air suction port and an air guide port communicating with the frame chamber, and the air suction port faces a storage position; and
the air exhaust element is mounted at the housing, and the air exhaust element is configured to provide power for discharging an airflow from the air guide port.

2. The heat dissipation device according to claim 1, wherein the air suction frame includes a longitudinal beam and a crossbeam mounted at the longitudinal beam, wherein:
the longitudinal beam and the crossbeam have hollow beam structures, an inner chamber of the crossbeam communicates with an inner chamber of the longitudinal beam, and the inner chamber of the crossbeam and the inner chamber of the longitudinal beam together form the frame chamber; and
the air suction port is formed at the crossbeam, and the air guide port is formed at the longitudinal beam.

3. The heat dissipation device according to claim 2, wherein a plurality of crossbeams are provided, arranged at intervals along an extension direction of the longitudinal beam, and are in a one-to-one correspondence with a plurality of storage positions of the housing.

4. The heat dissipation device according to claim 2, wherein an extension direction of the crossbeam is substantially parallel to a length direction of the storage position.

5. The heat dissipation device according to claim 2, wherein a plurality of air suction ports are provided at the crossbeam and arranged at intervals along an extension direction of the crossbeam.

6. The heat dissipation device according to any one of claims 1-5, wherein the housing includes an air outlet port, and the air guide port communicates with the air outlet port to allow the airflow discharged from the air guide port to be discharged to outside of the housing from the air outlet port.

7. The heat dissipation device according to claim 6,
wherein the housing further includes an air supply port;
the heat dissipation device further comprising a cooling assembly, the cooling assembly being configured to cool air outside the housing and send the air into the housing through the air supply port.

8. The heat dissipation device according to claim 7, wherein the air supply port is located above a moving path of an object to be cooled entering the housing.

9. The heat dissipation device according to claim 7, wherein the cooling assembly includes a shell body and a cooling element, wherein:
the shell body is fixedly connected to the housing, the shell body includes a cooling chamber, and the air outlet port and the air supply port communicate with the cooling chamber; and
the air exhaust element is further configured to provide power for airflow to flow from the air outlet port to the air supply port, and the cooling element is arranged in the cooling chamber, and is located in a flow path from the air outlet port to the air supply port.

10. The heat dissipation device according to claim 9, wherein the shell body further includes
a uniform flow chamber, the uniform flow chamber being arranged between the air outlet port and the cooling chamber; and
the uniform flow chamber includes a uniform flow element, the uniform flow element being configured to cause the airflow entering the uniform flow chamber to be uniformly distributed in a determined direction, the determined direction being substantially perpendicular to the flow path of the airflow from the air outlet port to the air supply port.

11. The heat dissipation device according to claim 10, wherein the uniform flow element includes a uniform flow board and a disturbance flow board fixedly connected to the shell body, wherein the uniform flow board includes a plurality of uniform flow holes arranged at intervals in the determined direction, the uniform flow chamber and the cooling chamber are arranged on two sides of the uniform flow board, respectively, and communicate via the plurality of uniform flow holes; and the disturbance flow board is configured to guide the airflow entering the uniform flow chamber along the determined direction.

12. The heat dissipation device according to claim 11, wherein a side wall of the shell body includes an air inlet port, the air inlet port communicates with the air outlet port, the uniform flow chamber is arranged between the air inlet port and the cooling chamber, and an instant flow direction of the airflow passing through the air inlet port is along the determined direction; and the disturbance flow board faces the air inlet port, the disturbance flow board and the uniform flow board are arranged at an interval to form an airflow channel between a side edge of the disturbance flow board and the uniform flow board along the determined direction, and the disturbance flow board includes a plurality of disturbance flow holes arranged in a dispersed manner.

13. The heat dissipation device according to claim 12, wherein the air inlet port communicates with the air outlet port through a connection pipeline.

14. The heat dissipation device according to claim 10, wherein the shell body further includes an air supply chamber, the air supply chamber communicates he cooling chamber with the air supply port, the air exhaust element is arranged between the cooling chamber and the air supply chamber, an inlet of the air exhaust element faces the cooling chamber, and an outlet of the air exhaust element faces the air supply chamber.

15. The heat dissipation device according to claim 14, wherein the air supply chamber includes a flow guide segment, the flow guide segment is arranged between the air exhaust element and the air supply port, and a flow through area of the air guide segment gradually decreases in a direction from the air exhaust element to the air supply port.

16. The heat dissipation device according to claim 14, wherein the air supply port is formed at a top wall of the housing; and the cooling assembly is arranged on the top wall of the housing, and the uniform flow chamber, the cooling chamber, and the air supply chamber are arranged sequentially in a horizontal direction.

17. The heat dissipation device according to claim 16, wherein an air supply grille is provided at a bottom wall of the air supply chamber, the air supply grille faces the air supply port, and the air supply chamber communicates with the air supply port through the air supply grille.

18. The heat dissipation device according to claim 9, wherein the cooling element includes a finned tube heat exchanger, a heat exchange body of the finned tube heat exchanger is accommodated in the cooling chamber, and a liquid inlet and a liquid outlet of the finned tube heat exchanger are both provided on the side wall of the shell body.

19. The heat dissipation device according to claim 9, wherein the shell body is detachably and fixedly connected to the housing.
